# EUROPEAN PATENT APPLICATION

(11) **EP 4 750 251 A1**
(43) Date of publication of application: **27.05.2026**
(21) Application number: 25212548.9
(22) Date of filing: 31.10.2025
(51) Int. Cl.: H10D 30/01, H10D 30/00, H10D 64/01, H10D 64/66, H10D 64/27, B82Y 10/00

(54) **NANORIBBON-BASED TRANSISTOR FABRICATION TECHNIQUES INCLUDING SACRIFICIAL LAYER OVER TOP NANORIBBON**

(30) Priority: 25.11.2024 US 202418958051
(71) Applicant: Intel Corporation, Santa Clara, CA 95054 (US)
(72) Inventor: Zhang, Yang, 87124 Rio Rancho, NM (US); Chu, Tao, 97229 Portland, OR (US); Zhang, Feng, 97229 Portland, OR (US); Zhang, Kan, 97123 Hillsboro, OR (US); Ghani, Tahir, 97229 Portland, OR (US); Golonzka, Oleg, 97007 Beaverton, OR (US); Lin, Chia-Ching, 97229 Portland, OR (US); Lin, Chung-Hsun, 97229 Portland, OR (US); Yeung, Chun Wing, 97229 Portland, OR (US); Xu, Guowei, 97229 Portland, OR (US); Hung, Ting-Hsiang, 97007 Beaverton, OR (US)
(74) Representative: Samson & Partner Patentanwälte mbB

(57) **Abstract**

Nanoribbon-based transistor fabrication techniques that use a sacrificial layer over the nanoribbon stack may enable more uniform deposition of the gate electrode material over the top nanoribbon in addition to protecting the top nanoribbon from damage resulting from subsequent processing. In one example, the technique may involve depositing a sacrificial layer (706), e.g., a dielectric material, over a stack of alternating layers of semiconductor material (702) that will subsequently be patterned into a fin and formed into a nanoribbon stack. After patterning the stack into a fin and releasing the nanoribbons of semiconductor material, the layer of sacrificial material (706) may act as a dummy nanoribbon over the top nanoribbon to enable deposition of the gate electrode material over the top nanoribbon having the same properties as the gate material between the nanoribbons.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIG. 2 is a flow diagram of an example method of fabricating an IC structure including using a sacrificial layer over a top nanoribbon, in accordance with some embodiments.
FIGS. 3-16 provide cross-sectional side views at various stages in the fabrication of an example IC structure according to the method of FIG. 2, in accordance with some embodiments.
FIG. 17 is a top view of a wafer and dies that may include any of the IC structures disclosed herein, in accordance with any of the embodiments disclosed herein.
FIG. 18 is a side, cross-sectional view of an IC device that may include any of the IC structures disclosed herein, in accordance with any of the embodiments disclosed herein.
FIG. 19 is a side, cross-sectional view of an IC package that may include any of the IC structures disclosed herein, in accordance with various embodiments.
FIG. 20 is a side, cross-sectional view of an IC device assembly that may include any of the IC structures disclosed herein, in accordance with any of the embodiments disclosed herein.
FIG. 21 is a block diagram of an example electrical device that may include any of the IC structures disclosed herein, in accordance with any of the embodiments disclosed herein.

### Detailed Description

Disclosed herein is a nanoribbon-based transistor fabrication method including use of a sacrificial layer over a top nanoribbon. The systems, methods, and devices of this disclosure each have several innovative aspects, no single one of which is solely responsible for all desirable attributes disclosed herein. Details of one or more implementations of the subject matter described in this specification are set forth in the description below and the accompanying drawings.

For purposes of illustrating fabrication of nanoribbon-based transistors using a sacrificial layer over a top nanoribbon, as described herein, it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

Nanoribbon-based transistors may be particularly advantageous for continued scaling of metal-oxide-semiconductor (MOS) technology nodes due to the potential to form gates on all four sides of a channel material (hence, such transistors are sometimes referred to as "gate all around" transistors). As used herein, the term "nanoribbon" refers to an elongated structure of a semiconductor material having a longitudinal axis parallel to a support structure (e.g., a substrate, a die, a chip, or a wafer; also referred to herein as, simply, "support") over which such a structure is built. Typically, a length of a such a structure (i.e., a dimension measured along the longitudinal axis, shown in the present drawings to be along the y-axis of an example x-y-z coordinate system) is greater than each of a width (i.e., a dimension measured along the x-axis of the example coordinate system shown in the present drawings) and a thickness (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon-based transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain (S/D) regions of a transistor provided on either side of the channel material.

Typically, nanoribbon-based transistor arrangements include stacks of nanoribbons, where each stack includes two or more nanoribbons stacked above one another, with a single gate stack that includes a gate electrode material (also known as the metal gate) provided for an entire stack or multiple stacks. Optionally, the gate stack may also include a gate dielectric material around one or more channel regions of each nanoribbon.

The processes involved in forming the gate stack may result in nonuniformities in the top nanoribbon of a nanoribbon stack and/or in the portion of the gate electrode material over the top nanoribbon. For example, when depositing the gate electrode material after releasing the nanoribbons, the gate electrode material is deposited on two sides (e.g., a top and bottom of the opening) for the lower nanoribbons, but is typically only deposited on one side for the top nanoribbon of the stack (e.g., only on the bottom of the opening). For example, a portion of gate electrode material between two nanoribbons is deposited on both nanoribbons, and those two portions of gate electrode material may merge together to form a continuous gate electrode material between those two ribbons. In contrast, a portion of gate electrode material formed over the top nanoribbon may be deposited only on the top of that nanoribbon, which may result in a thinner portion of gate electrode material over the top nanoribbon. Additionally, patterning performed after deposition of the gate electrode material may damage the top nanoribbon. For example, a dry etch process to remove patterning materials (e.g., a carbon hard mask), may result in damage to the top nanoribbon, which may cause performance issues.

In contrast, nanoribbon-based transistor fabrication techniques that use a sacrificial layer over the nanoribbon stack may enable more uniform deposition of the gate electrode material over the top nanoribbon in addition to protecting the top nanoribbon from damage resulting from subsequent processing. In one example, the technique may involve depositing a sacrificial layer (e.g., a dielectric material such as a silicon nitride, silicon carbon nitride, silicon oxycarbonitride, or another suitable dielectric material) over a stack of alternating layers of semiconductor material that will subsequently be patterned into a fin and formed into a nanoribbon stack. After patterning the stack into a fin and releasing the nanoribbons of semiconductor material, the layer of sacrificial material may act as a dummy nanoribbon over the top nanoribbon to enable deposition of the gate electrode material on two sides over the top nanoribbon. The dummy nanoribbon may act as a barrier to shield the top nanoribbon from damage due to subsequent processes. The dummy nanoribbon is later removed, and a conductive interconnect (e.g., a via) may be formed over and coupled with the top portion of the gate electrode material.

IC structures as described herein, in particular IC structures fabricated using nanoribbon-based transistor fabrication techniques using a sacrificial layer over the top nanoribbon, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures fabricated using nanoribbon-based transistor fabrication techniques using a sacrificial layer over the top nanoribbon as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices (e.g., physically coupled, conductively coupled, e.g., directly electrically connected). A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

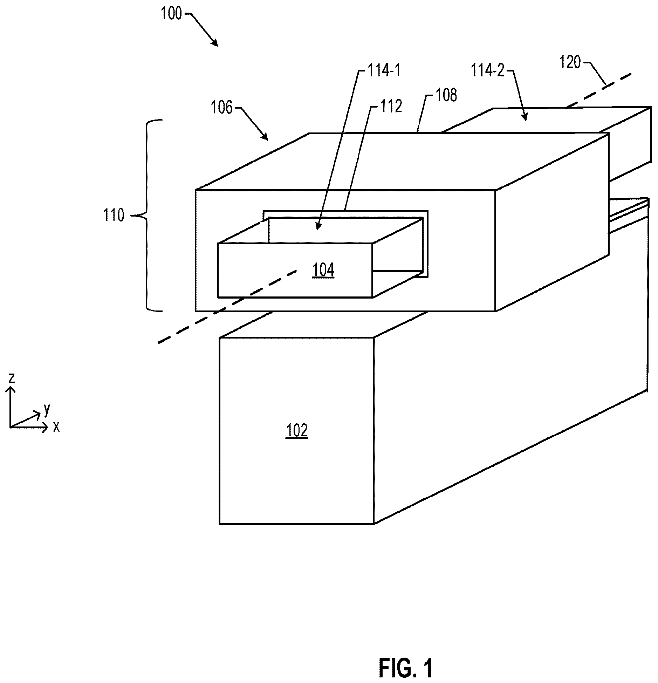

FIG. 1 provides a perspective view of an example IC structure 100 with a nanoribbon transistor 110, according to some embodiments of the present disclosure. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2, on either side of the gate stack 106. One of the S/D regions 114-1, 114-2 is a source region and the other one is a drain region. However, because, as is common in the field of FETs, designations of source and drain are often interchangeable, they are simply referred to herein as a first S/D region 114-1 and a second S/D region 114-2.

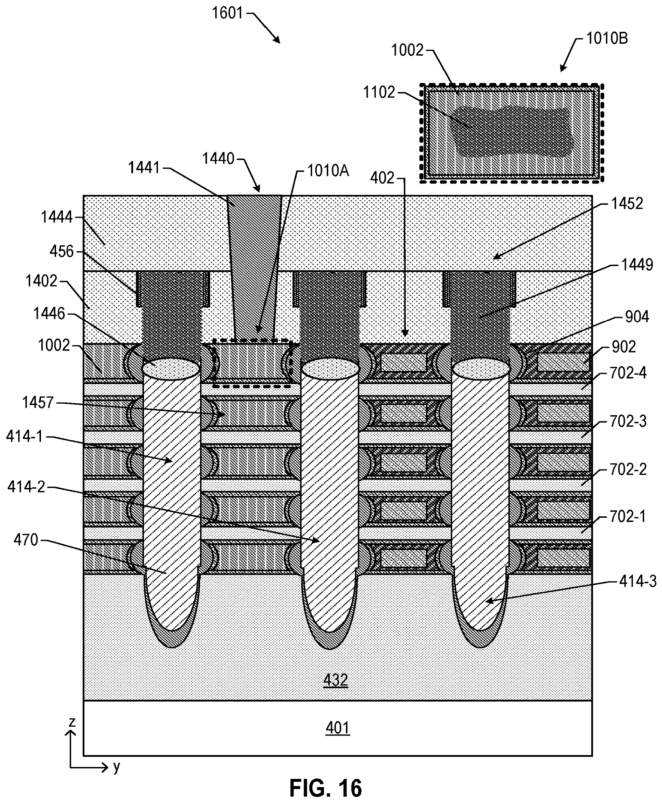

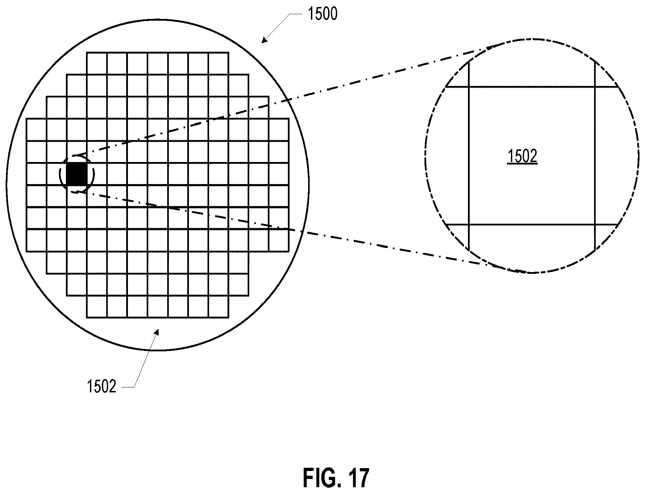

Implementations of the present disclosure may be formed or carried out on any suitable support 102, such as a substrate, a die, a wafer, or a chip. The support 102 may, e.g., be the wafer 1500 of FIG. 17, discussed below, and may be, or be included in, a die, e.g., the singulated die 1502 of FIG. 17, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure fabricated using nanoribbon-based transistor fabrication techniques using a sacrificial layer over the top nanoribbon as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIG. 16 shows IC structures that may be examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support 102 and in a direction perpendicular to the longitudinal axis 120 of the nanoribbon 104, e.g., along the x-axis of the coordinate system) may be at least about 3 times larger than a height or thickness of the nanoribbon 104 (i.e., a dimension measured in a plane perpendicular to the support 102, e.g., along the z-axis of the coordinate system), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some examples, nanoribbons of the same semiconductor material may be used to form NMOS and PMOS transistors. In such examples, the NMOS and PMOS transistors may be differentiated by depositing N-type or P-type work function metals around channel portions of those transistors.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, Nor P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor. For a PMOS transistor, gate electrode materials that may be used in different portions of the gate electrode material 108 may include, but are not limited to, tungsten, ruthenium, palladium, platinum, cobalt, nickel, and conductive metal oxides (e.g., ruthenium oxide), conductive metal nitrides (e.g., titanium nitride). For an NMOS transistor, gate electrode materials that may be used in different portions of the gate electrode material 108 include, but are not limited to, tungsten, hafnium, zirconium, titanium, tantalum, aluminum, alloys of these metals, and carbides of these metals (e.g., hafnium carbide, zirconium carbide, titanium carbide, tantalum carbide, and aluminum carbide, titanium aluminum carbide). In one example in which both an NMOS transistor and PMOS transistor include gate electrode materials that include tungsten, the gate electrode material including tungsten for the NMOS transistor may include fluorine, and the gate electrode material including tungsten for the PMOS transistor may be fluorine-free (e.g., fluorine may be substantially absent from a gate electrode material including tungsten for a PMOS transistor). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided below.

Turning to the S/D regions 114-1, 114-2 of the transistor 110, in some embodiments, the S/D regions may be highly doped, e.g., with dopant concentrations of about 10²¹ cm⁻³, in order to advantageously form Ohmic contacts with the respective S/D contacts (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. Even when doped to realize threshold voltage tuning as described herein, the channel portions of transistors typically include semiconductor materials with doping concentrations significantly smaller than those of the S/D regions 114-1, 114-2.

The S/D regions 114-1, 114-2 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114-1, 114-2. An epitaxial deposition process may then be carried out to fill the recesses with material that is used to fabricate the S/D regions 114-1, 114-2. In some implementations, the S/D regions 114-1, 114-2 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114-1, 114-2 may be formed using one or more alternate semiconductor materials such as germanium or a group III-V material or alloy. And in further embodiments, one or more layers of metal and/or metal alloys may be used to form the S/D regions 114-1, 114-2. In some embodiments, a distance between the first and second S/D regions 114-1, 114-2 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114-1, 114-2 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

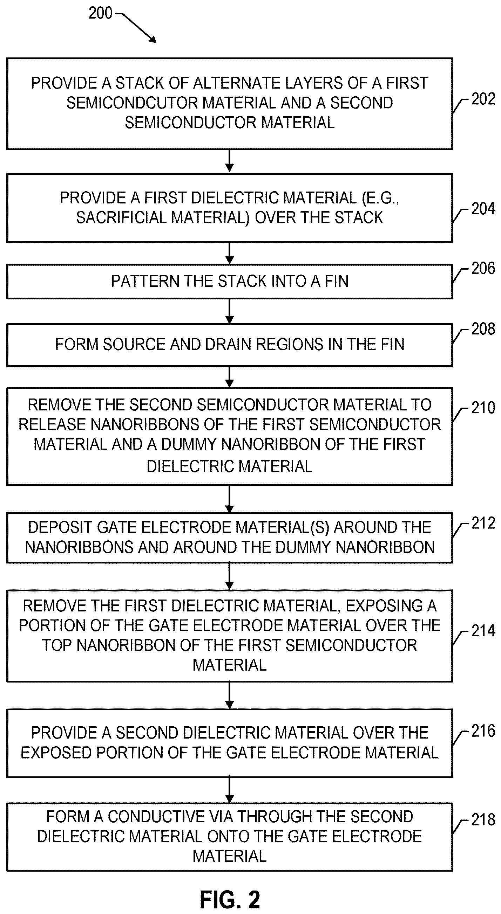

FIG. 2 is a flow diagram of an example method for fabricating an IC structure including nanoribbon-based transistors, where the method includes use of a sacrificial layer over the top nanoribbon, in accordance with some embodiments.

Although the operations of the method of FIG. 2 are illustrated once each and in a particular order, the operations may be performed in any suitable order and repeated as desired. For example, one or more operations may be performed in parallel to fabricate multiple IC structures with nanoribbon-based transistors using a sacrificial layer over a top nanoribbon substantially simultaneously. In another example, the operations may be performed in a different order to reflect the structure of an IC device fabricated using nanoribbon-based transistor fabrication techniques using a sacrificial layer over the top nanoribbon.

In addition, the example fabricating method of FIG. 2 may include other operations not specifically shown in FIG. 2, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 2 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

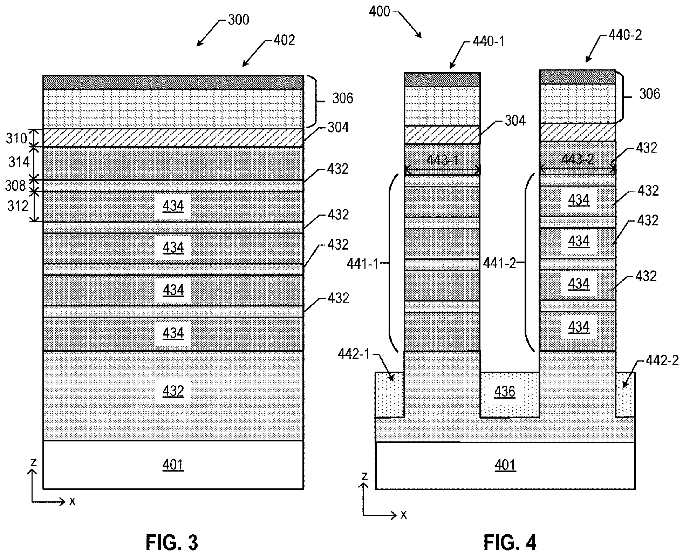

FIGS. 3-16 provide cross-sectional side views at various stages in the fabrication of an example IC structure according to the method of FIG. 2, in accordance with some embodiments.

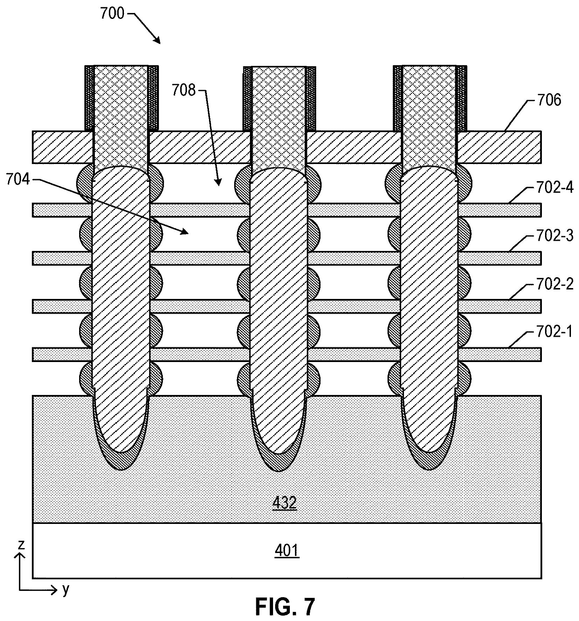

Turning to FIG. 2, the method 200 begins with a process 202 of providing a stack of alternate layers of a first semiconductor material and a second semiconductor material, and a process 204 of providing a dielectric material over the stack. The IC structure 300 of FIG. 3 is an example resulting IC structure of the processes 202 and 204. The IC structure 300 includes a support 401 and alternating layers of a semiconductor material 432 and layers of another material 434. While FIG. 3 illustrates five layers of the semiconductor material and four layers of the material 434 in a stack 402, in other embodiments, any other number of layers may be used as long as they are alternating and include at least three layers of the semiconductor material 432 and at least two layers of the material 434. The upper layers of the semiconductor material 432 will later be formed into nanoribbons stacked above one another, as shown in FIG. 7-16, discussed below. Thus, although a particular number of nanoribbons formed of the upper layers of the semiconductor material 432 is depicted in FIG. 7 (namely, four nanoribbons) and subsequent drawings, embodiments of the present disclosure include IC structures having more or fewer stacked nanoribbons than depicted.

As shown in FIG. 3, in some embodiments, the alternation of layers of the semiconductor material 432 and the material 434 may begin after a bottom layer of the semiconductor material 432 is provided over the support 401. In one such example, the bottom layer of the semiconductor material 432 may later form a subfin under the stack of nanoribbons. Although the thickness of the bottom layer of the semiconductor material 432 is depicted as being greater than the subsequent layers of the semiconductor material 432 that are formed into nanoribbons via further processing, in other examples, the bottom layer of the semiconductor material 432 may have a substantially same thickness as another layer of the semiconductor material 432.

The semiconductor material 432 may be any of the semiconductor/channel materials described above with reference to the nanoribbon 104 of FIG. 1. The material 434 may be any suitable material that is etch-selective with respect to the semiconductor material 432 so that, in a later process, the material 434 may be etched away to form nanoribbons of the semiconductor material 432. As known in the art, two materials are said to be "etch-selective" (or said to have "sufficient etch selectivity") with respect to one another when etchants used to etch one material do not substantially etch the other, enabling selective etching of one material but not the other. For example, in some embodiments, the semiconductor material 432 may be silicon while the material 434 may be a second semiconductor material such as silicon germanium. In another example, the semiconductor material 432 may be silicon germanium, while the material 434 may be silicon. In other examples, the material 434 may be made of a non-semiconductor material, e.g., of an insulator material, as long as this material is sufficiently etch-selective with respect to the semiconductor material 432.

Thus, the material 434 may be any suitable sacrificial material that is etch-selective with respect to the semiconductor material 432. Selecting the material 434 to be a semiconductor material may be particularly advantageous because it may improve the quality of the semiconductor material 432 if the semiconductor material 432 is epitaxially grown on the material 434. In some embodiments, the process 202 may include epitaxially growing layers of the semiconductor material 432 and the material 434 (e.g., a second semiconductor material) in an alternating manner. In other embodiments, alternate layers of the semiconductor material 432 and the material 434 may be provided in the process 202 using other techniques, such as layer transfer or thin-film deposition. Although FIG. 3 illustrates the same semiconductor material (e.g., the semiconductor material 432) in various layers of the IC structure 300, in general, material compositions of a semiconductor material from which nanoribbons will later be formed in different layers of the IC structure 300 may be different. For example, the semiconductor material 432 of one layer of the IC structure 300 may be silicon while the semiconductor material 432 of another layer of the IC structure 300 may be a III-N semiconductor material such as GaN.

The IC structure 300 also includes a layer of dielectric material 304 over the stack of alternating layers of semiconductor material 432 and material 434, and mask layers 306 (e.g., hard mask materials for patterning the stack into fins). In one example, the dielectric material 304 is a sacrificial material (e.g., a material that is removed in a later process). In some examples, the dielectric material 304 includes one or more of silicon, nitrogen, carbon, and oxygen (e.g., SiN, SiCN, SiOCN). In one such example, the dielectric material 304 is a nitride to enable etch selectivity with respect to oxide layers in subsequent processes. Any suitable deposition technique may be used to deposit the dielectric material 304 in the process 202, e.g., any suitable conformal deposition technique where the dielectric material 304 is provided on all exposed surfaces. Examples of deposition techniques that may be used in the process 202 include atomic layer deposition (ALD), chemical vapor deposition (CVD), plasma enhanced CVD (PECVD), or/and physical vapor deposition (PVD) processes such as sputter.

In some examples, the thickness 310 of the dielectric material 304 may be substantially the same as the thickness 308 of a layer of the semiconductor material 432 that will eventually be formed into nanoribbons (where the thickness 310 is a dimension of the dielectric material 304 in a plane substantially orthogonal to the support 401 or the nanoribbons of the semiconductor material 432, e.g., along the z-axis as shown in FIG. 3). In other examples, the thickness 310 may be greater than the thickness 308 (i.e., the thickness of the nanoribbons of the semiconductor material 432 may be smaller than the thickness 310 of the dielectric material 304). Similarly, the thickness 312 of the material 434 between adjacent layers of the semiconductor material 432 and the thickness 314 of the material 434 between the top layer of the semiconductor material 432 and the layer of dielectric material 304 may also be about the same, or may be different. In one example, the thickness 314 of the material 434 may be greater than the thickness 312. The thickness 310 of the dielectric material 304 and the thickness 314 of the material 434 directly below the dielectric material 304 may depend on a number of factors, including polish/etch margins in the fabrication process.

The method 200 continues with a process 206 of patterning the stack into a fin. FIG. 4 illustrates an example of an IC structure 400 resulting from the process of forming fins from the stack of alternate layers of semiconductor material and another material. The IC structure 400 illustrates that the stack 402 of alternating layers of the semiconductor material 432 and the material 434, and the layer of the dielectric material 304, has been patterned into fins 440-1, 440-2. The fins 440-1, 440-2 may include active portions 441-1, 441-2 and subfin portions 442-1, 442-2. The active portions 441-1, 441-2 may be portions of the fins 440-1, 440-2 from which the respective nanoribbons will be formed, while the subfin portions 442-1, 442-2 are portions of the fins 440-1, 440-2 that have sidewalls at least partially enclosed with an insulator material 436, e.g., as shown in FIG. 4. The insulator material 436 may include any of insulator material typically used as a "shallow trench insulator" (STI) in fin-based or nanoribbon-based transistors, e.g., any suitable low-k dielectric material or other suitable insulator material.

Thus, each of the fins 440-1, 440-2 may be shaped as a structure that extends away from the support 401 and may include a subfin or subfin portion 442-1, 442-2 at the bottom, the subfin being a portion of the respective fin that is at least partially enclosed by an insulator material 436. In some embodiments, the subfin portions 442-1, 442-2 may include the bottom layer of the semiconductor material 432, as well as an upper portion of the support 401, as is shown in FIG. 4. However, in other embodiments, the subfin portions 442-1, 442-2 may include only the semiconductor material 432 and not any portions of the support 401 (not shown in the present drawings). In some embodiments, semiconductor material 432 of the subfin portions 442-2, 442-2 and/or the support 401 may be removed and/or replaced with one or more other materials in subsequent processes.

In some embodiments, the fins 440-1, 440-2 may have widths (i.e., a dimension of the fins 440-1, 440-2 measured along the x-axis of the example coordinate system shown in FIG. 4) that are substantially the same or different. For example, the fin 440-1 has a width 443-1 and the fin 440-2 has a width 443-2. The widths 443-1, 443-2 may be that of the width of the nanoribbons subsequently formed (e.g., the nanoribbon 104 of FIG. 1 described above). The fins 440-1, 440-2 may further have a length (i.e., a dimension of the fins 440-1, 440-2 measured along the y-axis of the example coordinate system shown in FIG. 4, where the y-axis is going into and coming out of the page) suitable to account for the length of the future nanoribbons (e.g., as described above with reference to the length of the nanoribbon 104 of FIG. 1).

In various embodiments, any suitable patterning techniques may be used to form the fins 440-1, 440-2, such as, but not limited to, photolithographic or electron-beam (e-beam) patterning, possibly in conjunction with a suitable etching technique, e.g., a dry etch, such as e.g., RF reactive ion etch (RIE) or inductively coupled plasma (ICP) RIE. In some embodiments, the etch performed to form the fins 440-1, 440-2 may include an anisotropic etch, using etchants in a form of e.g., chemically active ionized gas (i.e., plasma) using e.g., bromine (Br) and chloride (CI) based chemistries. In some embodiments, during the etch to form the fins 440-1, 440-2, the IC structure may be heated to elevated temperatures, e.g., to temperatures between about room temperature and 200 degrees Celsius, including all values and ranges therein, to promote that byproducts of the etch are made sufficiently volatile to be removed from the surface.

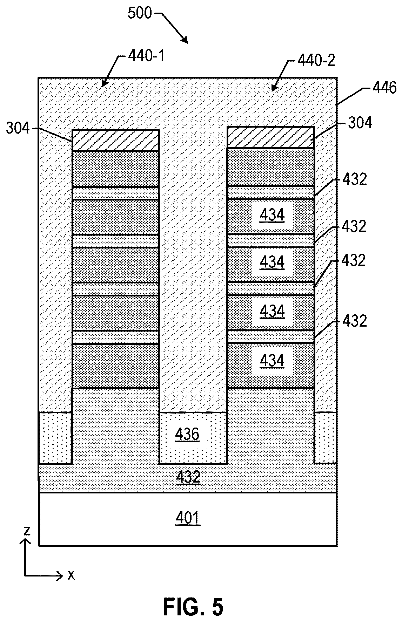

After forming the fins 440-1, 440-2, a dummy gate material may then be provided around gate regions of the fins. FIG. 5 illustrates an example IC structure 500 resulting from the process of providing a dummy gate. The IC structure 500 illustrates the fins 440-1, 440-2 over the support 401 and a material 446, which may be referred to as the dummy gate or replacement gate. In one example, the material 446 may be any suitable material such as polysilicon.

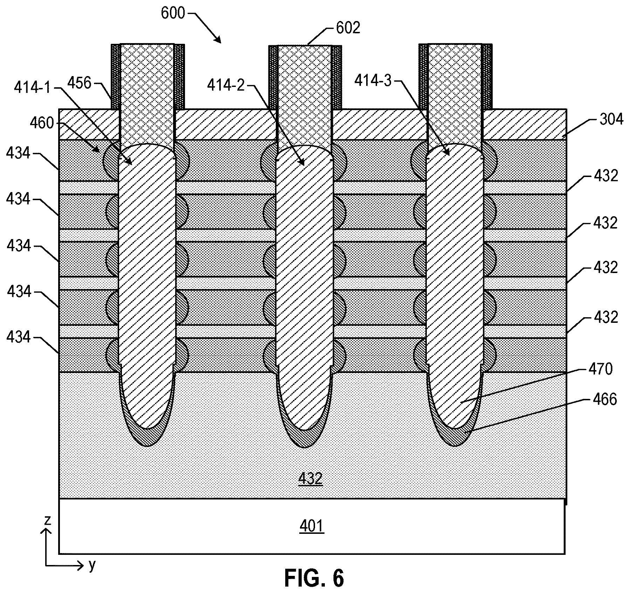

The method 200 continues with a process 208 of forming source and drain regions (S/D regions) in the fin. Forming S/D regions may involve, for example, forming S/D openings for the S/D regions in the fin, recessing a sacrificial material in the openings, providing a spacer material in the recessed areas, and providing an S/D material in the openings. The IC structure 600 of FIG. 6 is an example resulting IC structure 600 of the processes of forming S/D openings, recessing a sacrificial material in the openings, providing a spacer material in the recessed areas, and providing an S/D material in the openings.

Any suitable etching technique may be used to form S/D openings in the fin, such as the techniques described above with respect to the process of forming the fins. In some embodiments, portions of the openings (e.g., portions initially surrounded by the dummy gate, e.g., the material 446) may be lined with a liner 456. The liner 456 may include one or more of spacer materials, diffusion barrier materials, adhesion materials, etc., as known in the art for forming contacts to various components of IC structures. In one example, the liner 456 may include SiOC, SiOCN, or another suitable insulator material.

Recessing the sacrificial material (e.g., recessing the semiconductor material 434) in the openings may result in so-called "dimples" 460 may be formed in the sidewalls of the S/D openings in the fins, where the dimples 460 are areas in which the material 434 was recessed away from the original sidewalls of the openings (i.e., recessed laterally). Any suitable etching technique may be used in the process to recess the material 434 in the S/D openings, such as any suitable wet etching technique using etchants that can etch the material 434 without substantially etching other material of the IC structure 600. The dimples 460 may have any suitable geometry and dimensions so that, when filled with an insulator material, the dimples 460 may provide electrical insulation between the material of the S/D regions 414-1, 414-2, and 414-3 and the gate electrode material that will be present between the nanoribbons of the semiconductor material 432 formed from the fins 440-1, 440-2. For example, a depth of the dimples 460, which is a dimension that is measured along the y-axis of the example coordinate system shown, may be between about 1 and 20 nanometers, e.g., between about 2 and 10 nanometers, or between about 3 and 7 nanometers.

FIG. 6 also illustrates a spacer material 466 and S/D material 470 for the S/D regions in the S/D openings. In the example illustrated in FIG. 6, the dimples 460 may be filled with a spacer material 466. Furthermore, the spacer material 466 may also line bottoms of the openings. In one such example, the spacer material 466 lines the subfin portion of the fins 440-1, 440-2. The remaining portions of the openings may be filled with respective S/D materials, shown as a S/D material 470 in the openings. The spacer material 466 may include any suitable insulator material (e.g., SiO₂, SiOC, or another suitable insulator material), while the S/D materials 470 may include any materials for forming S/D regions (e.g., such as the S/D regions 114-1, 114-2 of FIG. 1) of nanoribbon-based transistors. In one example, the S/D material includes a doped semiconductor material. A further insulator material 602 may fill the openings over the S/D material 470. The insulator material 602 may include any suitable insulator material (e.g., SiO₂ or another suitable insulator material). In some examples, one or more of the liner 456, spacer material 466, and insulator material 602 may have the same or similar material composition (e.g., in one example, the liner 456 and the spacer material may both include silicon, oxygen, and carbon). Techniques for filling S/D openings with a spacer material and S/D material during fabrication of nanoribbon-based transistors are known in the art and, therefore, are not described here in detail.

The method 200 continues with a process 210 of removing the second semiconductor material to release nanoribbons of the first semiconductor material and a dummy nanoribbon of the first dielectric material. The IC structure 700 of FIG. 7 is an example resulting IC structure of the process 210. Removal of the second semiconductor material 434 may include any suitable etching technique. As a result of removing the material 434, a stack 708 of nanoribbons of the semiconductor material 432 is formed from the fin, where adjacent nanoribbons of the stack 708 are separated by openings 704. In the example illustrated in FIG. 7, there are four nanoribbons 702-1, 702-2, 702-3, and 702-4 in the stack 708. Thus, the nanoribbons of the stack 708 are "released" in that the openings 704 are formed around channel portions of the nanoribbons of the semiconductor material 432. A dummy nanoribbon 706 is also released by removal of the semiconductor material 434, where the dummy nanoribbon 706 is over the top nanoribbon 702-4 of the stack 708.

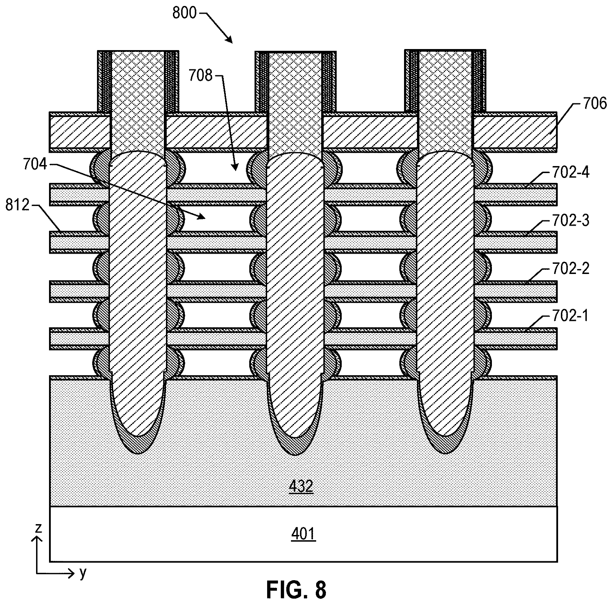

The method may continue with a process of providing a gate insulator material around gate regions of the nanoribbons of the stack. The IC structure 800 of FIG. 8 includes a gate insulator material 812 around the nanoribbons 702-1, 702-2, 702-3, and 702-4. The gate insulator material 812 may be an example of the gate insulator material 112. In some embodiments, the gate insulator material 812 may be absent in the IC structure 800.

Referring again to FIG. 2, the method 200 continues with a process 212 of depositing gate electrode material(s) around the nanoribbons and around the dummy nanoribbon. In some examples, NMOS and PMOS nanoribbon-based transistors may be formed with the same channel materials and different gate electrode materials (e.g., one or more different work function metals).

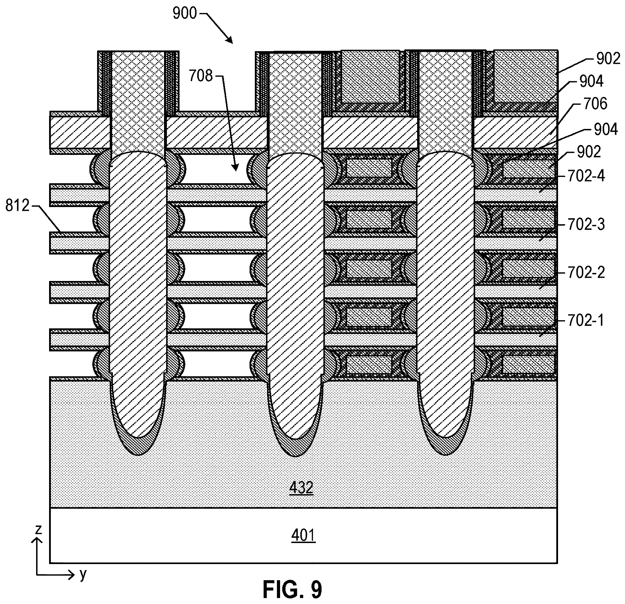

FIG. 9 illustrates an example IC structure 900 resulting from the process of providing gate electrode materials around portions of the nanoribbons for a PMOS transistor. In the example illustrated in FIG. 9, a conductive material 904 is deposited around portions of the nanoribbons 702-1, 702-2, 702-3, and 702-4 that are to form channel regions of a PMOS transistor. In one example, the conductive material 904 is a PMOS work function metal (e.g., a P-type work function metal suitable for PMOS devices). In one example, the conductive material 904 may include titanium and nitrogen (e.g., titanium nitride) or another suitable conductive material for forming a gate electrode for a PMOS transistor. The conductive material 904 may be deposited according to any suitable deposition technique. After depositing the conductive material 904 (e.g., a first P-type work function metal) the remaining openings may be filled by a further conductive material 902. In one such example, the conductive material 902 may also be a PMOS work function metal. In one example, the conductive material 902 may be or include tungsten or another suitable electrically conductive material.

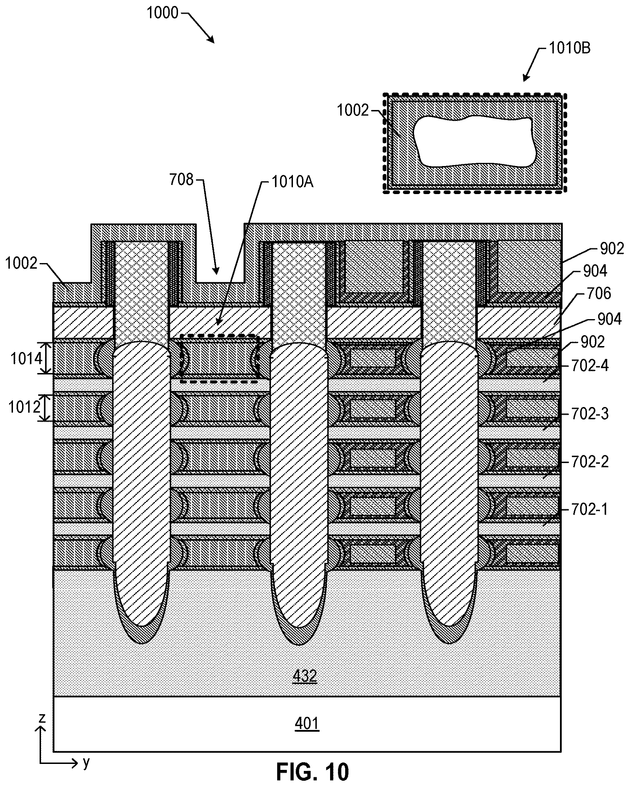

FIGS. 10-11 illustrate example IC structures 1000 and 1100 resulting from the process of providing gate electrode materials around portions of the nanoribbons for an NMOS transistor. Specifically, the IC structure 1000 of FIG. 10 illustrates a resulting IC structure after depositing a conductive material 1002 around the nanoribbons 702-1, 702-2, 702-3, and 702-4 and around the dielectric material 304 of the dummy nanoribbon 706. The conductive material 1002 may be deposited with any suitable deposition technique, and may include an NMOS work function metal (e.g., an N-type work function metal suitable for NMOS devices). In the example illustrated in FIGS. 3-10, the distance between adjacent nanoribbons of the stack 708 is about the same as the distance between the top nanoribbon 702-4 and the dielectric material 304 of the dummy nanoribbon 706. Therefore, the thickness 1012 of the conductive material 1002 between adjacent nanoribbons (e.g., between the nanoribbons 702-3 and 702-4) is about the same as the thickness 1014 of the conductive material 1002 between the top nanoribbon 702-4 and the dummy nanoribbon 706. In another example in which the dummy nanoribbon 706 is at a greater distance from the top nanoribbon 702-4, the first conductive material 1002 may not completely fill the opening between the top nanoribbon 702-4 and the dummy nanoribbon 706. As can be seen in FIG. 10, a region 1010A indicated with a dashed-line box shows an example in which the distance between the top nanoribbon 702-4 and the dummy nanoribbon 706 is about the same as the distance between adjacent nanoribbons, resulting in a continuous region of the conductive material 1002 between the top nanoribbon 702-4 and the dummy nanoribbon 706. This may be due to the conductive material 1002 being deposited on both the top of the top nanoribbon 702-4 and the bottom of the dummy nanoribbon 706, and the merging of those portions of the conductive material 1002 to form a continuous portion of the conductive material 1002. In contrast, in an example in which the distance is between the top nanoribbon 702-4 and the dummy nanoribbon 706 is greater than the distance between adjacent nanoribbons, the space between the top nanoribbon 702-4 and the dummy nanoribbon 706 may not be completely filled with the conductive material 1002 (e.g., the portions of the conductive material 1002 may not merge), as shown in the example region 1010B.

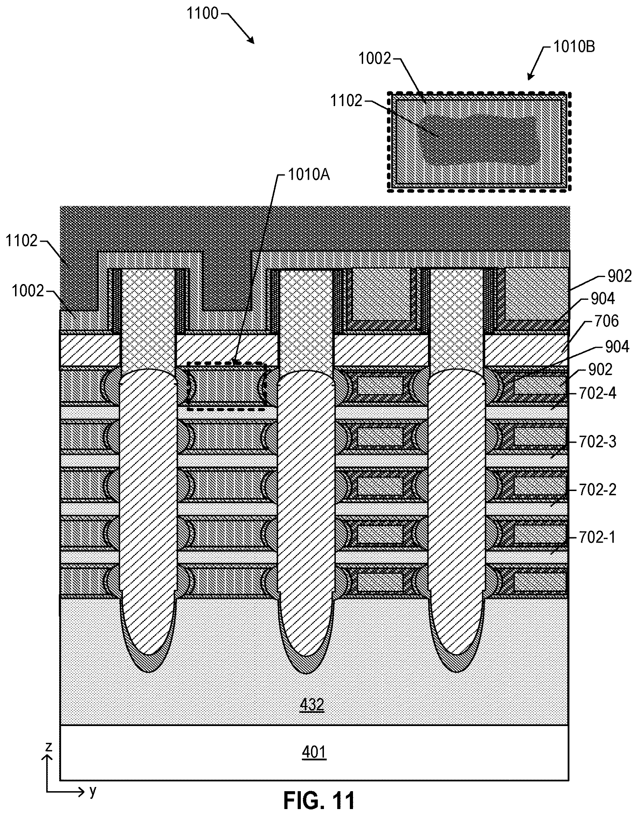

In one example, a further conductive material (e.g., a further N-type work function metal) is deposited over the conductive material 1002, as shown in FIG. 11. The IC structure 1100 of FIG. 11 includes a further conductive material 1102 over the conductive material 1002. The conductive material 1102 may be deposited with any suitable deposition technique, and may include an N-type work function metal. In one example, the conductive material 1002 is a metal carbide (e.g., includes one or more metals and carbon), and the further conductive material 1102 includes tungsten or another suitable conductive material. In an example in which the distance between the top nanoribbon 702-4 and the dummy nanoribbon 706 is large enough so that the initial N-type work function metal did not fill the opening (e.g., like in the example region 1010B), the conductive material 1102 may fill such an opening, resulting in a region of one conductive material 1102 between layers of another conductive material 1002.

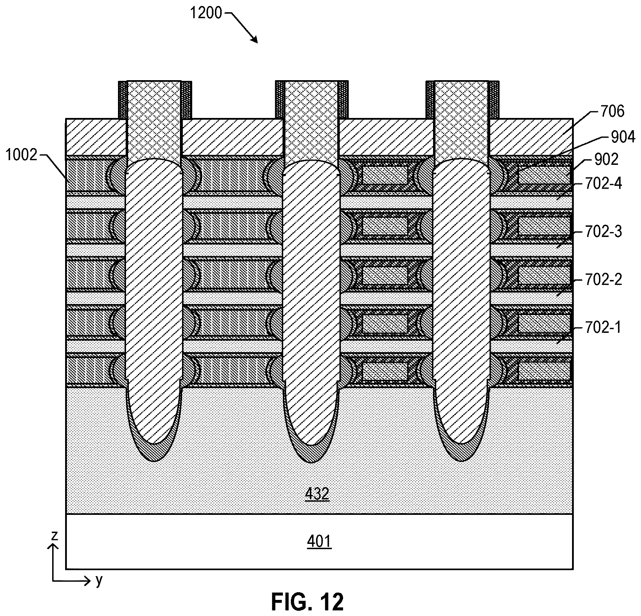

Unlike in some conventional techniques, in which a dielectric cap is deposited over the metal gates and the metal gates are recessed, the method 200 may not involve recessing the metal gates. In one such example, the method may involve polishing the IC structure to eventually remove the dummy nanoribbon. FIG. 12 illustrates an IC structure 1200 in which layers of conductive material have been polished to expose the dielectric material of the dummy nanoribbon 706.

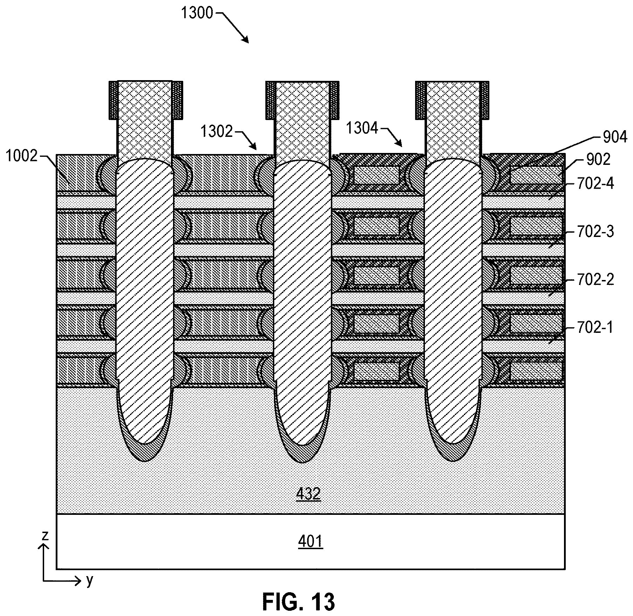

Referring again to FIG. 2, the method 200 continues with a process 214 of removing the first dielectric material, exposing a portion of the gate electrode material over the top nanoribbon. The IC structure 1300 of FIG. 13 is an example resulting IC structure of the process 214. Removal of the dummy nanoribbon 1706 may be accomplished with any suitable etch technique, such as those described above. As can be seen in FIG. 13, portions 1302 and 1304 of gate electrode material of the IC structure 1300 have been exposed by removal of the dielectric material 304 of the dummy nanoribbon 706. The portion 1302 is a portion of gate electrode material for an NMOS transistor, and the portion 1304 is a portion of gate electrode material for a PMOS transistor.

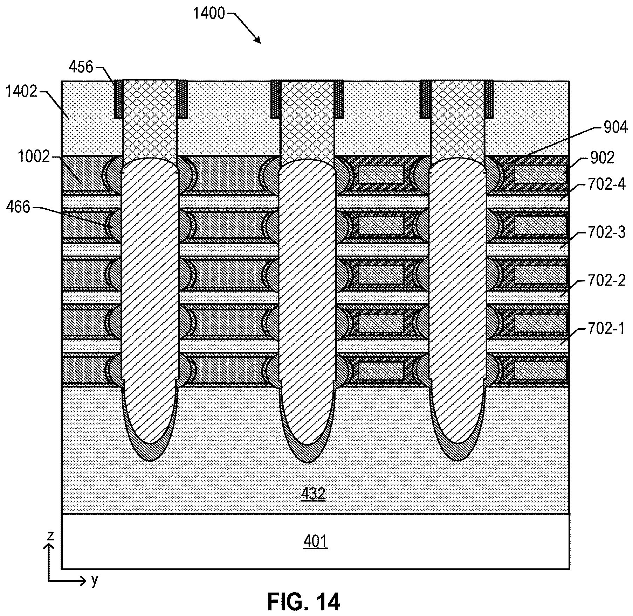

The method 200 continues with a process 216 of providing a second dielectric material over the exposed portion of gate electrode material. The second dielectric material may be deposited in accordance with any suitable deposition technique. The IC structure 1400 of FIG. 14 is an example resulting IC structure of the process 216. As can be seen in FIG. 14, the IC structure 1400 includes a layer of dielectric material 1402 over the exposed portions 1302, 1304 of gate electrode material. The dielectric material 1402 may include any suitable dielectric material, and may have substantially the same material composition as the spacer material 466 in the dimples 460, or a different material composition. The dielectric material 1402 may also have substantially the same material composition as the liner 456, or a different material composition from the liner 456. In one example, even where the material composition of two or more of the liner 456, spacer material 466, and dielectric material 1402 is substantially the same, they may appear in a cross-sectional image as distinct regions of an insulator material (e.g., due to the timing and processes used to deposit those materials).

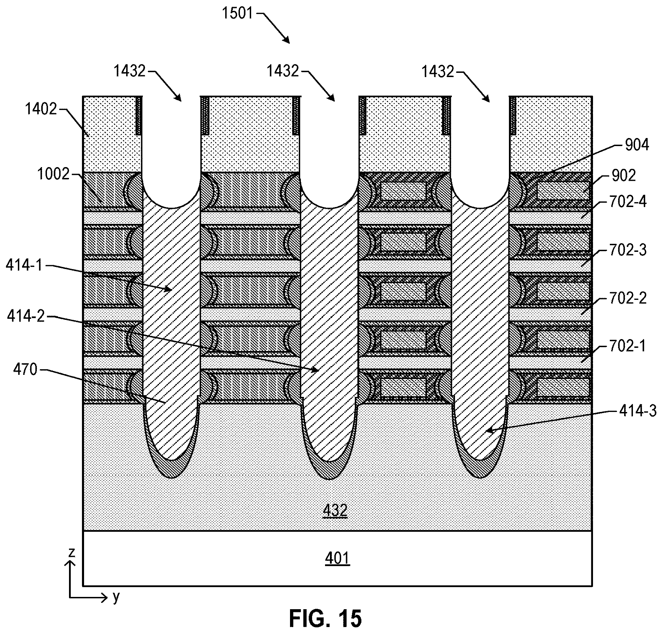

The method may then involve forming contact structures coupled with the S/D regions. Forming S/D contact structures may first involve forming contact openings over the S/D regions. Forming openings for S/D contact structures may involve any suitable etch techniques to remove the insulator material 602 over the S/D regions 414-1, 414-2, and 414-3. The IC structure 1501 of FIG. 15 illustrates an example resulting IC structure after forming S/D contact openings. As can be seen in FIG. 15, openings 1432 have been formed over the S/D regions 414-1, 414-2, and 414-3, exposing the doped semiconductor material 470 of the S/D regions 414-1, 414-2, and 414-3. Forming S/D contact structures may then involve the deposition of a conductive material (e.g., tungsten, cobalt, or another suitable conductive material) into the openings in accordance with any suitable technique, as can be seen in FIG. 16, discussed below.

Referring again to FIG. 2, the method 200 continues with a process 218 of forming a conductive via through the second dielectric material onto the portion of the gate electrode material over the top nanoribbon. Forming a conductive via coupled with the gate electrode material may involve depositing an additional layer 1444 of a dielectric material, forming an opening in the layer 1444 of dielectric material and in the dielectric material 1402, and filling the opening with a suitable conductive material 1441. The IC structure 1601 of FIG. 16 is an example resulting IC structure of the process 218. As can be seen in FIG. 16, the IC structure 1601 includes S/D contact structures 1452 including a conductive material 1449 coupled with the S/D regions 414-1, 414-2, and 414-3, and a conductive via 1440 including a conductive material 1441 over and coupled with the gate electrode material 1002 over the top nanoribbon 702-4. The contact structures 1452 may include an interface material (e.g., a silicide 1446, such as titanium silicide) between the S/D material 470 and the conductive material 1449.

Thus, the method 200 is an example method of fabricating an IC structure with nanoribbon-based transistors using a sacrificial material over the top nanoribbon, which may protect the top nanoribbon from damage and enable improved metal gate deposition over the top nanoribbon. Performing the method 200 may result in features in the final IC structures that are characteristic of the use of the method 200. For example, one such feature is illustrated in the IC structure 1601 shown in FIG. 16, which shows a stack 402 of two or more nanoribbons stacked over one another (e.g., the nanoribbons 702-1, 702-2, 702-3, and 702-4), a region of a doped semiconductor material in the stack (e.g., the region 414-1 of the doped semiconductor material 470), and a contact structure (e.g., the S/D contact structures 1452) over and coupled with the region 414-1, where the contact structure includes a first electrically conductive material 1449. The IC structure 1601 further includes a second electrically conductive material (e.g., the work function metal, e.g., the conductive material 1002) at least partially surrounding the two or more nanoribbons (which may also be referred to as a gate structure, metal gate, or gate stack). The work function metal of the gate structure includes a portion (e.g., a portion of the conductive material 1002 in the region 1010A or 1010B) of the second electrically conductive material over the top nanoribbon 702-4. The IC structure includes a conductive via 1440 that includes a third electrically conductive material 1441 over and in contact with the second electrically conductive material 1002 (e.g., of the regions 1010A or 1010B). The IC structure further includes a continuous dielectric material 1402 between and in contact with the first electrically conductive material (e.g., the conductive material 1449 of the contact structure 1452) and the third electrically conductive material (e.g., conductive material 1441 of the via 1440), and over and in contact with the second electrically conductive material (e.g., over and in contact with the work function metal of the metal gate, e.g., the conductive material 1002). Thus, in the example illustrated in FIG. 16, a continuous region of the dielectric material 1402 is between the S/D contact, the conductive via, and the WF metal of the metal gate.

Performing the method 200 may result in other features in the final IC structures that are characteristic of the use of the method 200. For example, the IC structure 1601 includes an insulator region (e.g., the spacer material 466 in a dimple 460) between the S/D region 414-1 and a portion of work function metal over the top nanoribbon 702-4, where the insulator region is below and in contact with the continuous dielectric material 1402. Also, as can be seen in FIG. 16, the IC structure 1601 includes a continuous portion of the work function metal (e.g., the conductive material 1002) between dimples, in contact with the dielectric material 1402 and in contact with the conductive via 1440. For example, a portion of work function metal in the region 1010A (or 1010B) includes a continuous portion of the second electrically conductive material (e.g., the conductive material 1002) between and coplanar with the first insulator region (e.g., the region of spacer material 466 in one dimple) and a second insulator region (e.g., the region of spacer material 466 in a dimple 460 on the other side of the gate electrode material), where the continuous portion of conductive material 1002 is in contact with the continuous dielectric material 1402, and in contact with the conductive via 1440. In one such example, even whether there is a region of another conductive material between layers of the work function metal (e.g., as shown in the example region 1010B), there is a continuous portion of the conductive material 1002 over the region of the further conductive material 1102.

Another feature that may result from performing the method 200 is shown in FIG. 16, in which the IC structure includes a portion of insulator material (e.g., the liner 456) between the S/D contact structure 1452 and the conductive via 1440, where the dielectric material 1402 is between the spacer material 466 in the dimple 460 and the liner 456 (e.g., where the first dielectric material 1402 is between the second dielectric material, e.g., of the liner 456, and the insulator region, e.g., the dimple 460). In one such example, the dielectric material 1402 is also in between the insulator material (e.g., the liner 456) and the work function metal over the top nanoribbon (e.g., the conductive material 1002).

Another feature that may result from performing the method 200 is shown in FIG. 16, in which the metal gate region over the top nanoribbon is thicker than the metal gate regions between adjacent nanoribbons, and where the metal gate region over the top nanoribbon may have a region of a different conductive material embedded in in another conductive material. For example, the IC structure includes a first portion of conductive material 1002 (e.g., in the region 1010A or 1010B) over the top nanoribbon 702-4 and a second portion of conductive material 1002 (e.g., in the region 1457) below the top nanoribbon 702-4 (e.g., the top nanoribbon 702-4 is between the first portion and the second portion of conductive material 1002). In one such example, only the top portion of the metal gate over the top nanoribbon may have the region of the different conductive material within another conductive material. For example, the conductive material 1102 may be absent from lower portions of the metal gate (e.g., absent from the portion of the metal gate between the top nanoribbon and a further nanoribbon below the top nanoribbon). In one such example, the first portion has a first thickness (e.g., the thickness 1014 shown in FIG. 10), where the first thickness is a first dimension of the first portion in a plane substantially orthogonal to the top nanoribbon 702-4, and the second portion has a second thickness (e.g., the thickness 1012 shown in FIG. 10) that is smaller than the first thickness, where the second thickness is a second dimension of the second portion in the plane. In one example, the first thickness of the gate electrode region above the top nanoribbon 702-4 is in a range of about 1 to 2 times the second thickness of the gate electrode region below the top nanoribbon. In one such example, if one or more of the lower metal gate portions have a thickness of about 10 nanometers, the top metal gate portion may have a thickness in a range of about 10-20 or 10-16 nanometers.

Note that although some examples above were described with respect to an N-type work function metal of an NMOS transistor, such examples may also apply to examples including a P-type work function metal of a PMOS transistor.

IC structures including nanoribbon-based transistors fabricated using a sacrificial layer over the top nanoribbon as described herein (e.g., as described with reference to FIGS. 1-16) may be used to implement any suitable components. For example, in various embodiments, transistors described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC structures disclosed herein, e.g., the IC structure 1601, may be included in any suitable electronic component. FIGS. 17-21 illustrate various examples of apparatuses that may include the IC structure 1601 disclosed herein.

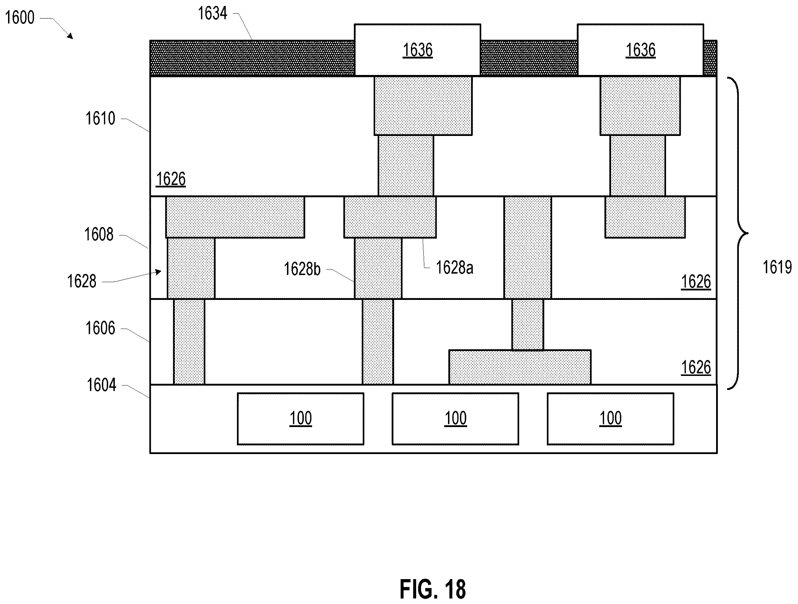

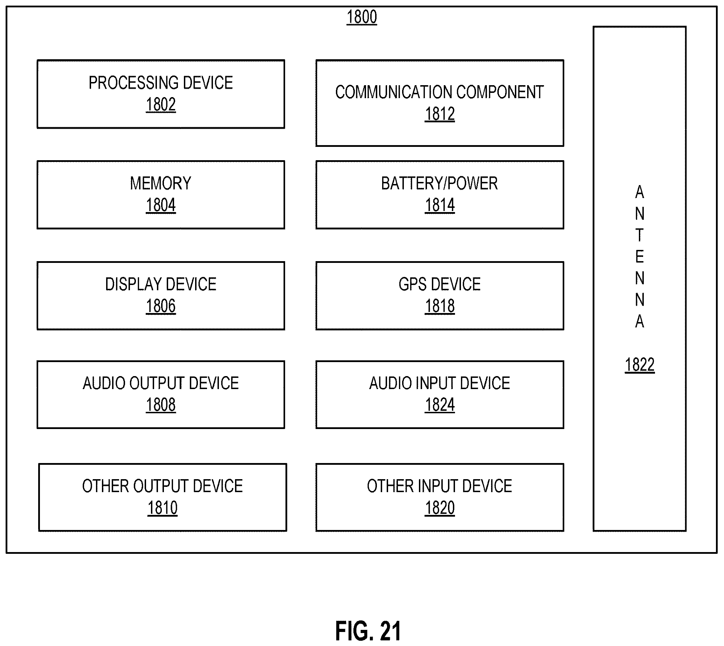

FIG. 17 is a top view of a wafer 1500 and dies 1502 that may include one or more IC structures 1601 in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures 1601 (e.g., as discussed below with reference to FIG. 18), one or more transistors (e.g., some of the transistors of the device region 1604 of FIG. 18, discussed below, e.g., nanoribbon-based transistors of the IC structures 1601) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 21) or other logic that is configured to store information in the memory devices or execute instructions stored in the memory array.

FIG. 18 is a side, cross-sectional view of an IC device 1600 that may include one or more IC structures in accordance with any of the embodiments disclosed herein (e.g., in accordance with IC structure 1601). One or more of the IC devices 1600 may be included in one or more dies 1502 (FIG. 17). The IC device 1600 may include a device region 1604 including one or more IC structures (e.g., one or more of IC structures 1601) disclosed herein, or any variations of the IC structures. The device region 1604 may further include electrical contacts to the gates of the transistors included in the device region 1604 and to the S/D materials of the transistors included in the device region 1604 (e.g., to the S/D regions 114-1, 114-2 of the IC structure 100).

Electrical signals, such as power and/or input/output (I/O) signals, may be routed to and/or from the devices (e.g., the transistors) of the device region 1604 through one or more interconnect layers disposed on the device region 1604 (illustrated in FIG. 18 as interconnect layers 1606-1610). For example, electrically conductive features of the device region 1604 (e.g., the gate electrode material 108 of the IC structure 100) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 18). Although a particular number of interconnect layers 1606-1610 is depicted in FIG. 18, embodiments of the present disclosure include IC structures having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the support 102 upon which the device region 1604 is formed. For example, the lines 1628a may route electrical signals in a direction in and out of the page from the perspective of FIG. 18. The vias 1628b may be arranged to route electrical signals in a direction of a plane that is substantially perpendicular to the surface of the support 102 upon which the device region 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 18. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts (e.g., contacts to the S/D regions 114-1, 114-2 of the IC structure 100) of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606-1610. In FIG. 18, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

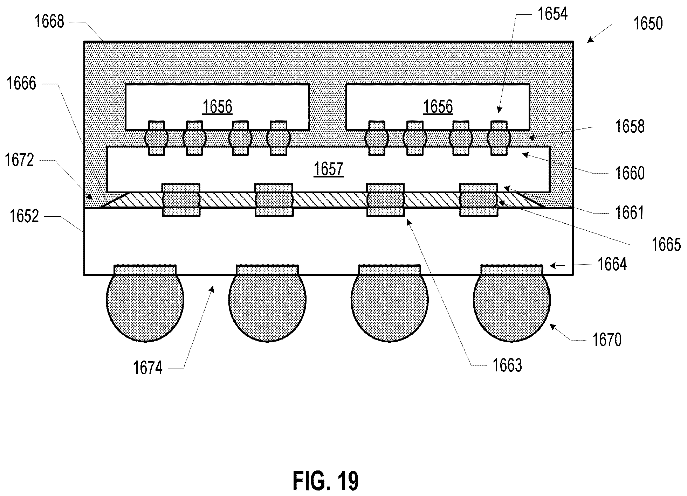

FIG. 19 is a side, cross-sectional view of an example IC package 1650 that may include one or more IC structures 1601 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 1628 discussed above with reference to FIG. 18.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 19 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 19 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

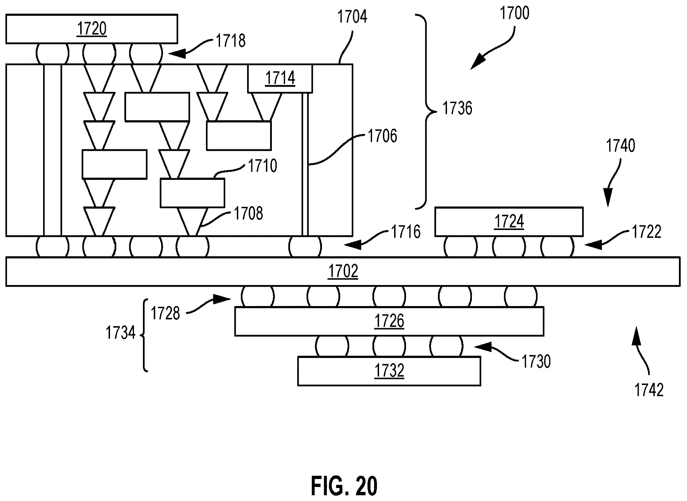

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 19 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 20.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multichip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 19 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 19, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 20 is a side, cross-sectional view of an IC device assembly 1700 that may include one or more IC packages or other electronic components (e.g., a die) including one or more IC structures 1601 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 19 (e.g., may include one or more IC structures 1601).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 20 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 20), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 20, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 17), an IC device (e.g., the IC device 1600 of FIG. 18), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 20, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 20 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 21 is a block diagram of an example electrical device 1800 that may include one or more IC structures 1601 in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 21 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 21, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include another output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a stack of two or more nanoribbons stacked over one another; a region (e.g., source or drain region) of a doped semiconductor material in the stack; a contact structure (e.g., S/D contact) over and coupled with the region, where the contact structure includes a first electrically conductive material; a second electrically conductive material (e.g., work function metal/gate electrode material) at least partially around the two or more nanoribbons, including a portion of the second electrically conductive material over a top nanoribbon of the stack; a conductive via including a third electrically conductive material over and in contact with the second electrically conductive material; and a continuous dielectric material between and in contact with the first electrically conductive material and the third electrically conductive material (e.g., between and in contact with the fill metal of the S/D contact and the via), and over and in contact with the second electrically conductive material (e.g., over and in contact with the work function metal of the metal gate).

Example 2 provides the IC structure of example 1, further including an insulator region (e.g., spacer material in a dimple) between the region (e.g., S/D region) and the portion (e.g., a top work function metal portion over the top nanoribbon), where the insulator region is below and in contact with the continuous dielectric material.

Example 3 provides the IC structure of example 2, where the insulator region is a first insulator region, and where the IC structure further includes a second insulator region (e.g., spacer material in another dimple adjacent to the other S/D region) coplanar with the first insulator region, where: the portion includes a continuous portion of the second electrically conductive material between and coplanar with the first insulator region and the second insulator region, in contact with the continuous dielectric material, and in contact with the conductive via (e.g., there is a continuous portion of the work function metal between dimples, in contact with the dielectric layer and in contact with the via).

Example 4 provides the IC structure of example 2, where the continuous dielectric material is a first dielectric material, and where the IC structure further includes a second dielectric material between the first electrically conductive material and the conductive via (e.g., the spacer between the S/D contact and the via), where the first dielectric material is between the second dielectric material and the insulator region (e.g., the dielectric layer directly over the gate is between the spacer material in the dimple and the spacer between the S/D contact and the via).

Example 5 provides the IC structure of any one of examples 1-3, where the continuous dielectric material is a first dielectric material, and where the IC structure further includes a second dielectric material between the first electrically conductive material and the conductive via (e.g., the spacer between the S/D contact and the via), where the first dielectric material is between the second dielectric material and the portion (e.g., the dielectric layer directly over the gate is between the metal gate and the spacer between the S/D contact and the via).

Example 6 provides the IC structure of any one of examples 1-5, where the portion is a first portion, and where the IC structure further includes a second portion of the second electrically conductive material, where: the top nanoribbon is between the first portion and the second portion, the first portion has a first thickness, where the first thickness is a first dimension of the first portion in a plane substantially orthogonal to the top nanoribbon, and the second portion has a second thickness that is smaller than the first thickness, where the second thickness is a second dimension of the second portion in the plane.

Example 7 provides the IC structure of example 6, where: the first thickness is in a range of about 1 to 2 times the second thickness (e.g., if the lower metal gate portions are about 10nm thick, the thickness of the top portion is in a range of 10-20 nm, or 10-16nm, as an example).

Example 8 provides the IC structure of example 6, further including a fourth electrically conductive material in the first portion between layers of the second electrically conductive material, where: the fourth electrically conductive material is absent from the second portion between the top nanoribbon and a further nanoribbon below the top nanoribbon.

Example 9 provides the IC structure of any one of examples 1-8, where: the continuous dielectric material is in direct contact with the first electrically conductive material (e.g., a liner is absent between the S/D contact and the dielectric layer).

Example 10 provides an IC structure, including a first nanoribbon of a semiconductor material and a second nanoribbon of the semiconductor material stacked over the first nanoribbon; a transistor including a region of a doped semiconductor material that is either a source region or a drain region of the transistor and a channel region, where a channel region of the transistor includes a first portion of the first nanoribbon and a second portion of the second nanoribbon; a gate structure coupled to the channel region, where the gate structure includes a first electrically conductive material around the channel region; a layer of a dielectric material over and in contact with the gate structure; and a contact structure (e.g., S/D contact) over and coupled with the region of the doped semiconductor material, where the contact structure includes a continuous portion of a second electrically conductive material between, coplanar with, and in contact with a first portion of the dielectric material and a second portion of the dielectric material.

Example 11 provides the IC structure of example 10, further including a conductive via over and coupled with the gate structure, where a continuous portion of the dielectric material is in between and in contact with the second electrically conductive material and the conductive via (e.g., the dielectric material is between and in contact with the S/D contact structure and the via).

Example 12 provides the IC structure of any one of examples 10-11, further including an insulator region (e.g., spacer material in a dimple) between the region (e.g., S/D region) and a top portion of the gate structure over (e.g., a top work function metal portion over the top nanoribbon), where the insulator region is below and in contact with the layer of the dielectric material.

Example 13 provides the IC structure of example 12, where the insulator region is a first insulator region, and where the IC structure further includes a second insulator region (e.g., spacer material in another dimple adjacent to the other S/D region) coplanar with the first insulator region, where: the top portion includes a continuous portion of the first electrically conductive material between and coplanar with the first insulator region and the second insulator region and in contact with the layer of the dielectric material (e.g., there is a continuous portion of the work function metal between dimples and in contact with the dielectric layer).

Example 14 provides the IC structure of any one of examples 10-13, where: the gate structure includes a first portion of the first electrically conductive material over the second nanoribbon and a second portion of the first electrically conductive material between the first nanoribbon and the second nanoribbon, and the first portion has a first thickness in a plane that is about 1-2 times a second thickness of the second portion in the plane.

Example 15 provides the IC structure of example 14, where: the first portion is thicker than the second portion.

Example 16 provides the IC structure of example 14, further including a third electrically conductive material in the first portion between layers of the first electrically conductive material in a plane that is substantially orthogonal to the first nanoribbon, where: the second portion includes a continuous portion of the first electrically conductive material between the first nanoribbon and the second nanoribbon in the plane.

Example 17 provides an IC structure according to any one of examples 1-16, where the IC structure includes or is a part of a central processing unit.

Example 18 provides an IC structure according to any one of examples 1-17, where the IC structure includes or is a part of a memory device.

Example 19 provides an IC structure according to any one of examples 1-18, where the IC structure includes or is a part of a logic circuit.

Example 20 provides an IC structure according to any one of examples 1-19, where the IC structure includes or is a part of input/output circuitry.

Example 21 provides an IC structure according to any one of examples 1-20, where the IC structure includes or is a part of a field programmable gate array transceiver.

Example 22 provides an IC structure according to any one of examples 1-21, where the IC structure includes or is a part of a field programmable gate array logic.

Example 23 provides an IC structure according to any one of examples 1-22, where the IC structure includes or is a part of a power delivery circuitry.

Example 24 provides an IC package that includes an IC die including an IC structure according to any one of examples 1-23; and a further IC component, coupled to the IC die.

Example 25 provides an IC package according to example 24 where the further IC component includes a package substrate.

Example 26 provides an IC package according to example 24, where the further IC component includes an interposer.

Example 27 provides an IC package according to example 24, where the further IC component includes a further IC die.

Example 28 provides a computing device that includes a carrier substrate, and an IC structure coupled to the carrier substrate, where the IC structure is an IC structure according to any one of examples 1-23, or the IC structure is included in the IC package according to any one of examples 24-27.

Example 29 provides a computing device according to example 28, where the computing device is a wearable or handheld computing device.

Example 30 provides a computing device according to examples 28 or 29, where the computing device further includes one or more communication chips.

Example 31 provides a computing device according to any one of examples 28-30, where the computing device further includes an antenna.

Example 32 provides a computing device according to any one of examples 28-31, where the carrier substrate is a motherboard.

Example 33 provides a method of fabricating an IC structure, the method including providing a stack including alternate layers of a first semiconductor material and a second semiconductor material and a layer of a first dielectric material over the alternate layers; patterning the stack into a fin; forming a first region and a second region of a doped semiconductor material in the fin; removing the second semiconductor material from the stack, where removal of the second semiconductor material exposes nanoribbons of the first semiconductor material (and a dummy nanoribbon of the dielectric material); providing a first conductive material around the nanoribbons and around the dielectric material; providing a second conductive material over the first conductive material; removing the first dielectric material, where removal of the first dielectric material exposes a portion of the first conductive material over the nanoribbons; providing a second dielectric material over the portion; and forming a conductive via through the second dielectric material over the portion.

Example 34 provides the method of example 33, where: providing the second conductive material includes depositing the second electrically conductive material between layers of the first conductive material over a top nanoribbon of the stack.

Example 35 provides the method of any one of examples 33-34, further including forming a contact structure over and coupled with the first region, where forming the contact structure includes forming an opening in the second dielectric material over the first region, and depositing a third electrically conductive material in the opening.

Example 36 provides the method of any one of examples 33-35, where: providing the stack includes providing the layer of the dielectric material with about a same thickness as a top layer of the first semiconductor material.

Example 37 provides a method according to any one of examples 33-36, where the IC structure is an IC structure according to any one of the preceding examples.

Example 38 provides a process of making an IC structure according to the method of any one of examples 33-36.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a stack of two or more nanoribbons stacked over one another;
a region of a doped semiconductor material in the stack;
a contact structure over and coupled with the region, wherein the contact structure comprises a first electrically conductive material;
a second electrically conductive material at least partially around the two or more nanoribbons, including a portion of the second electrically conductive material over a top nanoribbon of the stack;
a conductive via comprising a third electrically conductive material over and in contact with the second electrically conductive material; and
a continuous dielectric material between and in contact with the first electrically conductive material and the third electrically conductive material, and over and in contact with the second electrically conductive material.

2. The IC structure of claim 1, further comprising:
an insulator region between the region and the portion, wherein the insulator region is below and in contact with the continuous dielectric material.

3. The IC structure of claim 2, wherein the insulator region is a first insulator region, and wherein the IC structure further comprises:
a second insulator region coplanar with the first insulator region, wherein:
the portion comprises a continuous portion of the second electrically conductive material between and coplanar with the first insulator region and the second insulator region, in contact with the continuous dielectric material, and in contact with the conductive via.

4. The IC structure of claim 2, wherein the continuous dielectric material is a first dielectric material, and wherein the IC structure further comprises:
a second dielectric material between the first electrically conductive material and the conductive via, wherein the first dielectric material is between the second dielectric material and the insulator region.

5. The IC structure of any one of claims 1-4, wherein the continuous dielectric material is a first dielectric material, and wherein the IC structure further comprises:
a second dielectric material between the first electrically conductive material and the conductive via, wherein the first dielectric material is between the second dielectric material and the portion.

6. The IC structure of any one of claims 1-5, wherein the portion is a first portion, and wherein the IC structure further comprises:
a second portion of the second electrically conductive material, wherein:
the top nanoribbon is between the first portion and the second portion,
the first portion has a first thickness, wherein the first thickness is a first dimension of the first portion in a plane substantially orthogonal to the top nanoribbon, and
the second portion has a second thickness that is smaller than the first thickness, wherein the second thickness is a second dimension of the second portion in the plane.

7. The IC structure of claim 6, wherein:
the first thickness is in a range of about 1 to 2 times the second thickness.

8. The IC structure of claim 6, further comprising:
a fourth electrically conductive material in the first portion between layers of the second electrically conductive material, wherein:
the fourth electrically conductive material is absent from the second portion between the top nanoribbon and a further nanoribbon below the top nanoribbon.

9. The IC structure of any one of claims 1-8, wherein:
the continuous dielectric material is in direct contact with the first electrically conductive material.

10. A method of fabricating an integrated circuit (IC) structure, the method comprising:
providing a stack comprising alternate layers of a first semiconductor material and a second semiconductor material and a layer of a first dielectric material over the alternate layers;
patterning the stack into a fin;
forming a first region and a second region of a doped semiconductor material in the fin;
removing the second semiconductor material from the stack, wherein removal of the second semiconductor material exposes nanoribbons of the first semiconductor material;
providing a first conductive material around the nanoribbons and around the dielectric material;
providing a second conductive material over the first conductive material;
removing the first dielectric material, wherein removal of the first dielectric material exposes a portion of the first conductive material over the nanoribbons;
providing a second dielectric material over the portion; and
forming a conductive via through the second dielectric material over the portion.

11. The method of claim 10, wherein:
providing the second conductive material comprises depositing the second conductive material between layers of the first conductive material over a top nanoribbon of the stack.

12. The method of any one of claims 10-11, further comprising:
forming a contact structure over and coupled with the first region, wherein forming the contact structure comprises:
forming an opening in the second dielectric material over the first region, and depositing a third conductive material in the opening.

13. The method of any one of claims 10-12, wherein:
providing the stack comprises: providing the layer of the dielectric material with about a same thickness as a top layer of the first semiconductor material.

14. The method of any one of claims 10-13, wherein:
the stack comprises a first layer of the second semiconductor material over a top layer of the first semiconductor material and a second layer of the second semiconductor material below the top layer of the first semiconductor material,
the first layer has a first thickness,
the second layer has a second thickness, and
the first thickness is greater than the second thickness.

15. The method of any one of claims 10-14, further comprising:
providing a gate insulator material at least partially around a gate region of the nanoribbons and at least partially around the first dielectric material.
